(19) Europäisches Patentamt
European Patent Office
Office européen des brevets

(11) **EP 4 068 140 A1**

(12) **EUROPEAN PATENT APPLICATION**

(43) Date of publication:
**05.10.2022 Bulletin 2022/40**

(21) Application number: **21165949.5**

(22) Date of filing: **30.03.2021**

(51) International Patent Classification (IPC):
***G06F 30/27*** *(2020.01)*

(52) Cooperative Patent Classification (CPC):
**G06F 30/27**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Aktiengesellschaft 80333 München (DE)**

(72) Inventors:
- **Berger, Daniel**
  **90443 Nürnberg (DE)**
- **Lavrik, Vladimir**
  **63303 Dreieich (DE)**
- **Klos, Hans-Henning**
  **91249 Weigendorf (DE)**
- **Paulitsch, Christoph**
  **76199 Karlsruhe (DE)**

(54) **METHOD AND SYSTEM FOR OPTIMIZING A SIMULATION MODEL USING MACHINE LEARNING**

(57)     A method of providing, preferably optimizing, a simulation model (2) of an actual system (1), the actual system (1) having a plurality of operating states (7), comprising the steps of: obtaining, preferably measured by one or more sensors, actual system output data (4), the actual system output data (4) representing a response of the actual system (1) to system input data (3), preferably also measured by one or more sensors, determining, by a machine learning model (5), one or more scores (6), the one or more scores (6) indicating an importance of one or more features (9) for classifying the actual system output data (4) and/or the simulation model output data (8) by the machine learning model (5) into at least one of the operating states (7), identifying one or more parameters (21, 22, 23) of the simulation model (2) based on the one or more scores (6), and adapting the one or more parameters (21, 22, 23) of the simulation model (2).

FIG 13

EP 4 068 140 A1

**Description**

TECHNICAL FIELD

The present disclosure relates to the field of simulation software for modeling and/or analyzing a system. Simulation software is part of the systems engineering domain and falls into the mechatronic engineering field.

BRACKGROUND

The Digital Twin - and in particular - the executable Digital Twin (exDT) is considered one of the most disruptive technologies in the next decade. These digital twins are able to comprehend the impact of design changes on the production system and provide engineers, operators and service technicians with essential information to optimize the use and performance of a product and prevent system outages. Technically, this is realized by combining simulation models and real-life data, creating "hybrid models" of physical assets that keep the digital twin in sync with the real world.

In many application scenarios an accurate system simulation model is desirable. Especially in the context of condition monitoring and adaptive control strategies for failure cases an accurate representation of failure modes through a system simulation model is vital. Such a simulation model requires the proper choice of parameters (i.e. springs) to represent the physics of a failure as well optimized parameters values (i.e. spring constants) typically calibrated with measured data.

Simcenter Amesim is the leading integrated, scalable system simulation platform, allowing system simulation engineers to virtually assess and optimize the performance of mechatronic systems. This boosts overall systems engineering productivity from the early development stages until the final performance validation and controls calibration. Simcenter Amesim combines ready-to-use multi-physics libraries with the application- and industry-oriented solutions that are supported by powerful platform capabilities, to let you rapidly create models and accurately perform analysis. This open environment can be easily coupled with major computer-aided engineering (CAE), computer-aided design (CAD), and controls software packages.

SUMMARY

It is therefore desirable to accurately model the behavior and/or make assessments and/or make predictions regarding the operation of the actual (real world) system.

The present disclosure proposes machine learning techniques which performs the optimization of a simulation model in a highly effective way.

According to a first aspect a method of providing, preferably optimizing, a simulation model of an actual system, the actual system having a plurality of operating states, is proposed. The method comprising the step of obtaining, preferably measured by one or more sensors, actual system output data, the actual system output data representing a response of the actual system to system input data, preferably also measured by one or more sensors. The method comprising the step of determining, by a machine learning model, one or more scores, the one or more scores indicating an importance of one or more features for classifying the actual system output data and/or the simulation model output data by the machine learning model into at least one of the operating states. The method may further comprise the step of identifying one or more parameters of the simulation model based on the one or more scores. The method may further comprise the step of adapting the one or more parameters of the simulation model, e.g. based on the one or more scores.

According to a second aspect an apparatus operative to perform the steps according to the first aspect is proposed.

According to a third aspect a non-transitory computer-readable storage medium, storing computer-executable instructions that when executed, e.g., by a processing circuitry, perform the steps according to the first aspect, is proposed.

These and other objects, features, and advantages of the present disclosure will become apparent upon reading the following Detailed Description in view of the Drawings briefly described below.

BRIEF DESCRIPTION OF THE DRAWINGS

DETAILED DESCRIPTION

Figure 1    illustrates actual input and, actual output, i.e. the response to the input, of an actual system.
Figure 2    illustrates actual input and the response of an simulation model to the actual input.
Figure 3    illustrates an exemplary embodiment of actual input in the form of measured velocity and the response the simulation model in the form of a simulated torque.

Figure 4     illustrates an exemplary embodiment of an actual system in the form of a conveyor system.
Figure 5     illustrates an exemplary embodiment of a simulation model of the conveyor system.
Figure 6     illustrates a simulated output by the simulation model compared to reference measurements of the actual system.
Figure 7     illustrates an optimization of a simulation model based on actual system input data.
Figure 8     illustrates the preparation of a simulation model of a nominal operation.
Figure 9     illustrates the preparation of a simulation model of an abnormal operation.
Figure 10    illustrates the classification of input data into one or more operating states and the extraction of one or more feature importance score.
Figure 11    illustrates an exemplary example of features and respective importance scores for the vibrational frequencies of a conveyor system.
Figure 12    illustrates a first embodiment of optimization of a simulation model based in the importance scores extracted from a machine learning model.
Figure 13    illustrates a second embodiment of optimization of a simulation model based in the importance scores extracted from a machine learning model.
Figure 14    illustrates the preparation of an optimized simulation model by adapting the simulation model's parameters.
Figure 15    illustrates a third embodiment of optimization of a simulation model based on resampling data sets from the input data.

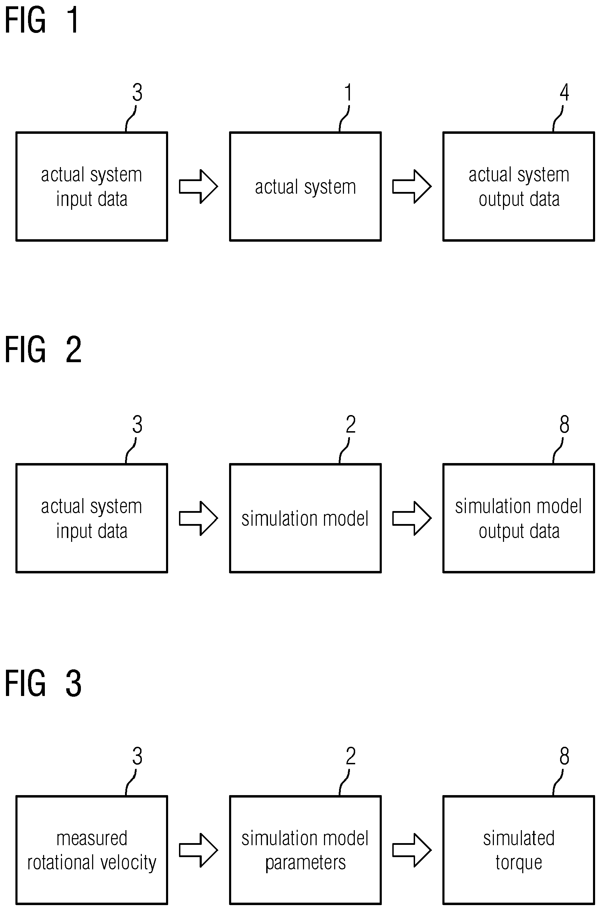

Figure 1 illustrates actual system input data 3 and, actual system output data 4, i.e. the response of the actual (real world) system 1, such as an aircraft engine or wind turbine, to the actual system input data. The actual system input data 3 is put into the actual system 1 and actual system output data 4 is obtained. The actual system output data 4 are the results obtained after running a process in the actual system 1. This process may be performed by one or more parts of the actual system 1. The actual system 1 may be composed of interacting parts that operate together to achieve an objective or purpose. The actual system 1 is thus intended to obtain inputs, process them in some way and produce outputs. The actual system input data 3 and the actual system output data 4 may be in the form of a time series. For example, the actual system input data 3 may be measured data, e.g., in the form of a time series, corresponding to one or more measured system properties. The actual system output data 4 may also be measured data (also in the form of a time series) corresponding to another system property. The actual system input data 3 and the actual system output data 4 may be measured by one or more sensors. The sensors being operative to measure the respective actual system 1 property.

It is often desirable to model behaviors and/or make assessments and/or make predictions regarding the operation of the actual system 1, i.e. the real world physical system, such as an electromechanical system. For example, it may be helpful to predict a Remaining Useful Life ("RUL") of an actual system 1 to help plan when the actual system 1 or one or more parts thereof should be replaced. Likewise, an owner or operator of such an actual system 1 might want to monitor one or more conditions of the actual system 1, or one or more parts of the system 1, to help make maintenance decisions and the like. Even with improvements in sensor and computer technologies, however, accurately making such assessments and/or predictions can be a difficult task. For example, an event that occurs while an actual system 1 is not operating might impact the RUL and/or one or more conditions of the actual system 1 but it may not be taken into account by typical approaches to system assessment and/or prediction processes.

Turning to Figure 2, actual system input data 3 and the response of a simulation model 2 to the actual system input data 3, i.e. simulation model output data 8 is shown.

A simulation model 2 may be understood as a computer simulation of an actual (complex technical) system 1, for example an aircraft engine or wind turbine or other electromechanical system. This requires solving different aspects of physics, electronics and/or controlling. A simulation model 2 may be understood as a model which represents the actual (technical) system which is to be simulated. It may be built up by a number of sub models each representing a subsystem, e.g. a system simulation model for a car may contain a sub model for the engine, the chassis, the tires and so on. Each simulation model 2 comes with a multitude of parameters which together describe the system. The simulation model parameters may be understood as the set of all parameters which describe the actual system 1. Typically, these parameters have physical meanings, like stiffness, pressure, and/or temperature.

Simulation models 2 cannot magically reproduce reality but require input from the real world, i.e. actual system input data 3. In order to optimize the simulation model 2 and its parameters measured data from the actual (real world) system it aims to represent is used, for example a pair of measured input and measured output of the actual system 1. For example, as shown in Figure 3, in the case of a conveyor belt, the measured input is the rotational velocity 3 of the electric drive and the system response is the torque measured at the electric drive, as shown in Figure 3. All elements of the system simulation model and their parameters are then object to optimization to minimize the difference between measured and simulated response of the actual system. Hence, as shown in Figure 3, based on simulation model parameters of the simulation model simulation model output data in the form of a simulated torque may be obtained. To that end, the simulation model takes the measured rotational velocity as an input and provides the simulated torque as an output, i.e. as simulation model output data. As will be described later in more detail, it is a goal of the optimization of the simulation model to adapt the simulation model parameters so that the simulation model output data matches the actual system output data, in particular for certain features identified in the simulation model output data, and preferably based on the same actual system input data input in the simulation model 2 and the actual system 1.

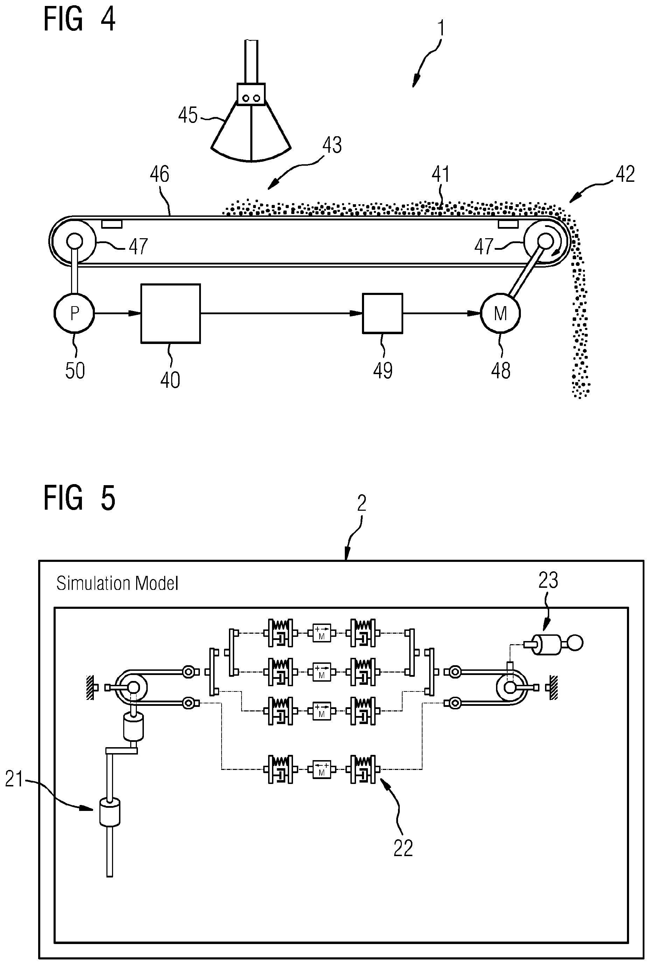

Figure 4 illustrates an exemplary embodiment of an actual system 1 in the form of a conveyor system. Bulk material 41 is loaded onto the conveyor device 42 at a feed location. The manner in which the bulk material 41 is loaded onto the conveyor device 2 by means of a gripper 45, as illustrated in Figure 4, is purely exemplary in this case. According to Figure 4, the conveyor device 42 has a conveyor belt 46. The conveyor belt 46 is guided over two deflection rollers 47, with one of the deflection rollers 47 being driven by means of a drive 48. The drive 48 is controlled by a control device 49. The control device 49 is, in turn, connected to a control computer 40 which an operator 11 can use, inter alia, to detect and influence the operating state of the conveyor system.

The conveyor belt 46 is subject to wear during operation. The control computer 40 therefore may also serve for identifying the condition of the conveyor belt 46. This control computer 40 is operatively connected to one or more sensors 50. The control computer 40 may also have a connection to the one or more sensors 50.

The control computer 40 may capture actual system input data and/or actual system output data, e.g., rotational velocity of the drive 48 and/or torque of the conveyor belt 46. The control computer 40 may be connected to an edge device and/or a cloud, not shown.

A simulation model of the conveyor system 1 is shown in Figure 5. The simulation model 2 may be used for condition monitoring of the conveyor system. The simulation model 2 may be stored and/or executed by the control computer, the edge device and/or the cloud. As the case may be, a simulation model 2 of the actual system 1 may be needed for each condition the system might experience, i.e. for each one of a plurality of operating states of the actual system 1. In the present case, a looseness of the central rubber band should be detected. This means that a simulation model 2 is needed to represent the rubber belt in a good condition, i.e. a nominal operating state, and another one representing the belt in a bad condition (the belt is loosed), i.e. in an abnormal operating state, with the only difference being the values of the system simulation parameters.

A problem lies in the difficulty of obtaining a simulation model 2 which accurately allows to distinguish between the different conditions or operating states. In general, this requires the adequate choice for the topology of the simulation model 2 (the types of parameters, and the order the parameters are connected) as well as optimized parameter values for each simulation model parameter. The parameter space is high dimensional (easily in the order of hundred parameters), rendering a significant computational challenge to any optimization routine.

In the present case the conveyor system is modeled using different simulation model parameters 21, 22, 23. Here, rotational parameters 21, 23 are used to represent the electric motor. Furthermore, the model comprises parameters 22 for different masses and springs 22 to represent the rubber belt and its dynamical response to some input rotational velocity. The simulation model 2 shall represent different failure modes of the actual system 1 and the simulation model 2 may thus be used in the context of predictive maintenance and/or failure classification. In this example, two operating states of the actual system are considered: the rubber belt is in "good" condition (nominal operation), or the rubber belt is in "bad" condition (abnormal operation).

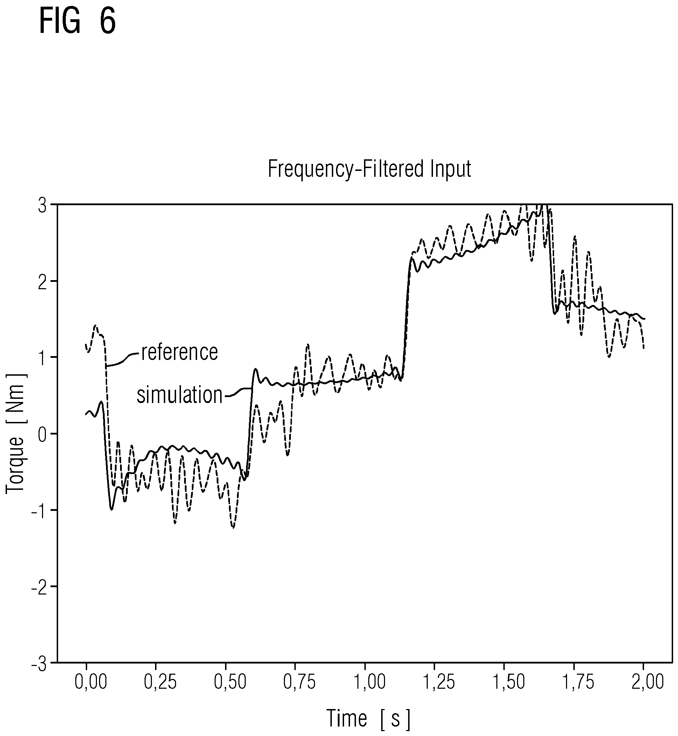

In Figure 6 a simulation model 2 output data by the simulation model compared to reference measurements (actual model output data) of the actual system 1 is shown. Ideally (given a perfect system representation and/or perfectly fit system simulation parameters), both curves coincide. In practice, this is not possible. Furthermore, the criteria to accept a system simulation model 2 as accurate enough is not clear. In this aspect, the present disclosure provides a self-consistent, automatable prescription which focusses the optimization of the simulation model parameters to match the most important features of the actual system output data. It is proposed to make use of a machine learning model in order to determine one or more features that carry the necessary information to distinguish between "good" (nominal operation) and "bad" (abnormal operation) case or between one or more operating states in general. The optimization is thus focused to match the most important features, which allow a classification of the operating state(s) of the system, of the actual system output data and the respective features of the simulation model output data. A feature importance score can be extracted from the machine learning model, e.g. decision tree, which is trained to perform the classification. First however, certain aspects of the optimization of a simulation model will be described.

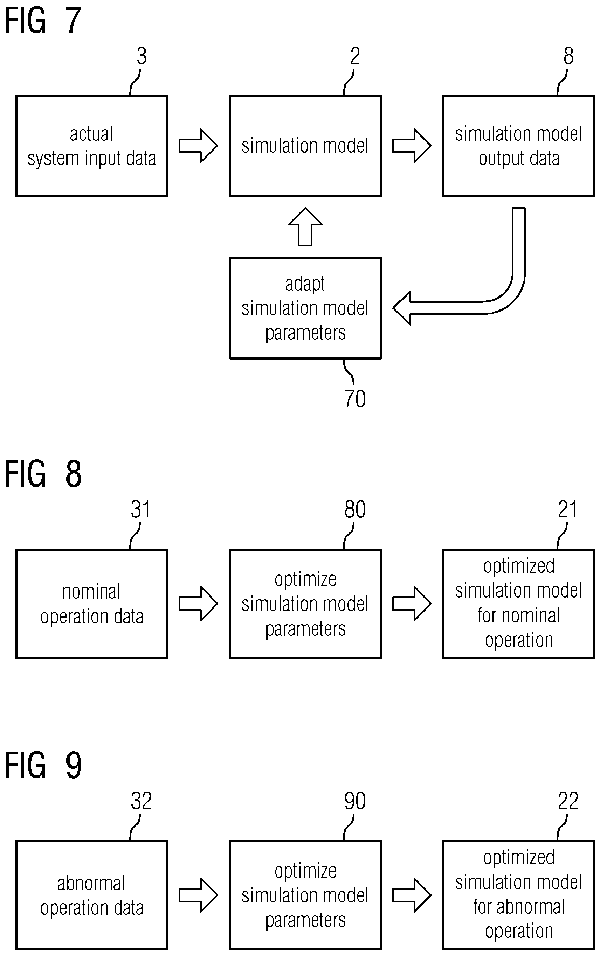

Figure 7 illustrates an optimization of a simulation model 2 based on actual system input data 3. Often the optimization of a simulation model 2 is performed manually through trial-and-error. More sophisticated approaches exploit (global) optimization algorithms which search the parameter space of the simulation model 2 for optimal values. This in general valid approach, however, has two shortcomings: The (global) optimization of the degrees of freedom of the simulation model 2 is a substantial challenge and needs to be a tradeoff between accuracy and computability. On the one hand, the simulation model 2 needs a certain degree of complexity for a good representation of the actual system 1. This, however, comes with an exploding number of simulation model parameters, which poses an increasing challenge to the optimization procedure. On the other hand, if the simulation model 2 is simplified too much, the simulation model 2 is not able to represent the reality accurately enough; especially to accommodate subtle features pointing to failure modes. As shown in Figure 7, simulation model output data 8 obtained (based on actual system input data 3 processed by the simulation model 2) is analyzed in order to adapt the simulation model parameters 70 and to match the actual system output data 4 (obtained for the same actual system input data). The simulation model 2 comprising the adapted simulation model parameters may then be executed again in order to check whether the simulation model output data now provides a more accurate match to the actual system output data. Once, a satisfying accuracy has been reached the simulation model 2 may be used for condition monitoring, predictive maintenance etc. of the actual system 1.

Figure 8 illustrates the preparation of an optimized simulation model 21 for nominal operation, whereas Figure 9 illustrates the preparation of a simulation model 22 for abnormal operation. The actual system 1 may produce nominal operation data 31 and abnormal operation data 32. Nominal operation data 31 corresponds to the system output data 3 during nominal operation, i.e. during which the actual system 1 operates according to the desired specification and exhibits the desired, normal behavior. Abnormal operation data 32 corresponds to the system output data 3 during abnormal operation, i.e. during which the actual system 1 does not operate according to the desired specification and exhibits an undesired, abnormal behavior. As the case may be, there are multiple nominal operating states during which the system operates exhibits the desired, normal operation. The same is true for the abnormal operation, i.e. there may be multiple abnormal operating states during which the system does not exhibit the desired behavior, e.g. is at fault. In both cases it may be necessary to obtain an optimized simulation model 21, 22. That is, one or more simulation models 21 may be provided that simulate the actual system 1 during its nominal operation. Furthermore, one or more simulation models 22 may be provided that describe the abnormal operation of the actual system 1. It should be understood that the simulation models 21, 22 for the nominal and abnormal operating states may be aggregated into a superordinated simulation model, comprising simulation models 21, 22 for each one of the plurality of operating states of the actual system 1. As shown, it may be desired to optimize the simulation model parameters 80, 90 in order to best reflect the actual system's behavior. As a result, one or more optimized simulation models 21, 22 for each one of the plurality of operating states of the actual system 1 may be obtained.

Up to now, the decision which features (of the actual system output data) need to be focused on, is either coming from domain expertise of the engineer, simple trial-and-error, or in the best case coming from a sophisticated but separate analysis of the measurement data, i.e. actual system input/output data.

In a pure data analytics (DA) approach to measurement data, international patent application WO 2018/089957A1 suggest an autonomous DA system which learns features from measurements on-the-fly for condition monitoring, to twin a physical system. The DA system learns, and extracts features from measurement data to classify the condition of the physical system; the cost function which is minimized is the misclassification rate of the measurement data. In contrast to the present approach, no simulation model is involved in the above mentioned patent application. This however has strong implications for the feature selection, i.e. the actual usefulness of the extracted features as some features might not be accessible/reproducible in the simulation.

Another approach for simulation model optimization is a sensitivity analysis on the simulation model parameters, in order to find out the simulation model parameters that have the greatest gradient in a certain configuration of the full parameter set. The procedure is as follows:

1. Quantify the uncertainty in each input (e.g. ranges, probability distributions).
2. Identify the simulation model output to be analyzed.
3. Run the simulation model a number of times using some design of experiments.
4. Using the resulting model outputs, calculate one or more sensitivity measures of interest.

Alternatively, a derivative-based approach, calculating the partial derivative of the simulation model output data $Y$ in respect to the simulation model parameter $X_i$ (all other simulation model parameters stay fixed, $X^0$) may be used:

$$\left| \partial X_i \right|_{\mathbf{x}^0}$$

Other methods for sensitivity analysis of the simulation model parameters may involve regression analysis, variogram analysis of response surfaces etc. Variance based methods may also be applied to calculate feature importance, one of them being Principal Component Analysis, PCA.

After finding the sensitivity for each simulation model parameter, the simulation model parameters with the highest sensitivity may be chosen for parameter tuning. This causes that more sensitive simulation model parameters are tuned more, in order to converge more quickly, e.g. in combination with Levenberg-Marquardt algorithm, to deal with local minima.

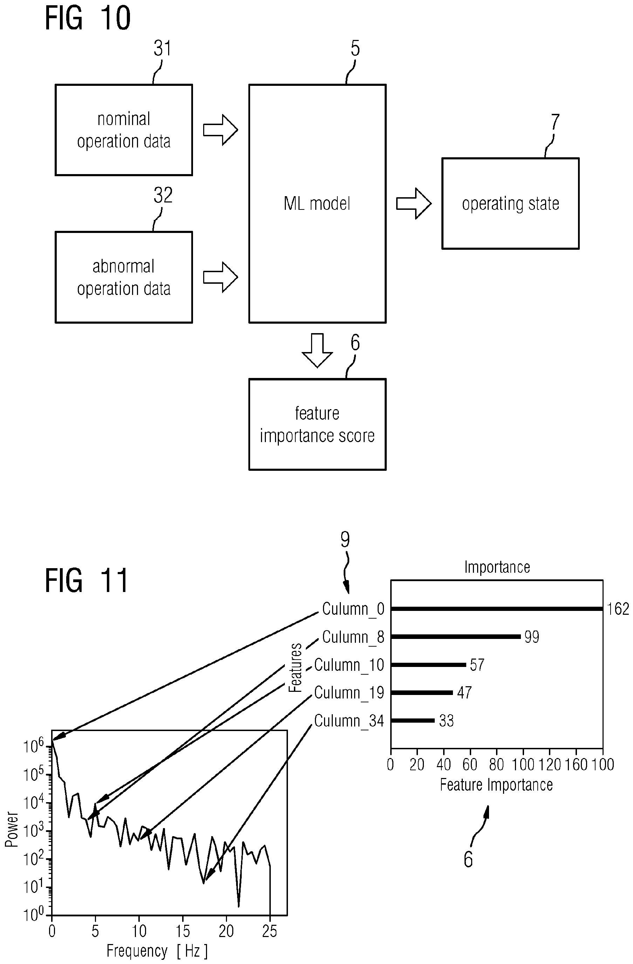

Now, further improvements to the optimization of a simulation model and the identification of features for optimization are described with regard to Figure 10. According to an embodiment a method and software, comprising computer-readable instructions, e.g., executable by a processing circuitry, for example on an edge device or inside a cloud, is proposed. By way of the method one or more simulation models for different failure cases may be obtained, preferably optimized, by using actual system output data, e.g., nominal and/or abnormal operation data 31, 32, e.g., measured data. The method may involve a machine learning model 5 in order to focus optimization of the simulation model on the most important features. These features may be identified based on classifying the actual system output data by the machine learning model. The method may further involve including the classification result of the machine learning model into the cost function to be optimized. This method may be completely automated, and can run "in-operando" for continues learning. The machine learning model 5 may serve for classifying the data 31 and/or 32 into one or more of the operating states of the actual system. To that end the machine learning model may be trained using labelled operation data, e.g., in the form of operation data during a nominal operating state and/or an abnormal operating state. The ML model learns how to distinguish the "good" and the "bad" case based on the features of the actual system output data. The machine learning model 5 is typically trained on actual system output data, and also delivers which features of the actual system output data are most suitable to distinguish between "good" and "bad" case or between different operating state in general. At a later stage, the machine learning model 5 may be used to classify the simulation model output data by evaluating the feature values of the most important features of the simulation output data. Furthermore, the feature importance score may be used as weights in the cost function.

For exemplary purposes, first, a basic method of optimization ("Basic Procedure") is described. Thereafter it is described how to incorporate the entire set of measurements (actual system output data) for the purpose of optimization ("Generalized Procedure"). The latter will remove the issue of overfitting leading to a much more robust and more generally valid simulation model.

Figure 10-12 show the workflow for the "Basic Procedure". This approach aims to optimize the simulation model parameters by determining the most important features a machine learning model 5 uses for classification, i.e. to distinguish between the "good" and the "bad" case (e.g. certain vibrational modes in the measured data). First, these features need to be extracted and the machine learning model 5 for classification needs to be trained.

As shown in Figure 10, the machine learning model 5 may obtain for training and/or classification nominal operation data and/or abnormal operation data. For training the machine learning model 5 labeled actual system input data and/or actual system output data may be obtained. The label may correspond to the operating state of the actual system during which the nominal/abnormal operation data 31, 32 have been obtained. The (trained) machine learning model 5 may then classify the operation data 31, 32 input into one of the operating states 7 of the actual system 1.

The machine learning model 5 may further be used to extract a score 6 for one or more of the features that are used for classifying the operation data 31, 32 input. In the example of the conveyor belt, the machine learning model 5 may be used to identify vibrational frequencies of the rubber belt which allow to distinguish between the good and the bad case, i.e. the machine learning model 5 allows to distinguish between one or more nominal operating states 7 and one or more abnormal operating states 7.

In order to determine a score 6 of a feature's importance, different methods can be applied. For example, a Principal Component Analysis Technique (PCA) may be applied, but also other sensitivity analysis methods may be used. The feature importance scores 6 may be scaled to add up to 100%.

The score 6 indicating the importance of the respective feature may subsequently be used adapt one or more of the simulation model parameters. As will be described later in more detail, a cost function C may be introduced that takes into account the importance score 6 in order to minimize the difference between the feature values obtained from the actual system output data and the feature values obtained from the simulation model output data.

The machine learning model 5 may thus be used to extract the (most important) features for classifying the actual system output data into the one or more operating states of the actual system. Alternatively, a separate software module performing the feature extraction can be provided. The actual system input data typically carries no response information and will not be used to classify the operating state of the actual system. Subsequently, the features extracted from the actual system output data and the features (and/or respective feature values) extracted from the simulation model output data can be compared. As a result of the comparison the simulation model parameters can be adapted in such a way that the difference between the features obtained from the actual system output data and the features from simulation model output data is minimized. To that end, the simulation model may be enhanced to include additional parameters, e.g., additional springs modelling the rubber band, or the simulation model parameter values may be changed. In practice, a global optimization driver is employed to explore the simulation model parameter space and to adapt the one or more simulation model parameters. Techniques such as differential evolutionary algorithms, Bayesian optimization, or the SHERPA algorithm in the Siemens product HEEDS, may be used to perform this task in an efficient way.

In Figure 11 the features used by the machine learning model 5 for classifying the actual system output data into the one or more operating states are shown. A feature ma be understood as a measurable property of the actual system. In da-tasets, a feature may appear as a column. As can be seen, certain features 9, denoted as Column_0, Column_8, Column_10, Column_19 and Column_34 in Figure 11, corresponding to certain vibrational frequencies in the case of the conveyor system example, have a higher importance score 6 than others when it comes to classifying the data input into an operating state of the actual system. The respective frequencies are identified by the arrows in Figure 11 and an importance score for the respective feature, in the present case a frequency, is given by way of a bar chart illustrating the score 6. As a consequence, the optimization of the simulation model can be focused on the most important features. The simulation model parameters may then be optimized, e.g., comprising all or only a subset of the simulation model parameters of the simulation model, in order to match best match these feature values. Returning to the example of the conveyor system, this means that the optimization of the simulation model will be performed to best match the most important features (as identified by the machine learning model 5). Thus, the optimization of the simulation model may be focused on the most important features and as a result the same feature values are obtained based on the simulation model output data and based on the actual system output data.

The most important features may comprise a predetermined number of features with the highest score, e.g., the first three, four, or five, etc. features sorted according to the features' score may be used for the optimization. Alternatively, a threshold score may be set and the features having a score above said threshold score may be selected for the optimization. Features having a score below said threshold score may be neglected as the optimization is focused on the more important features.

As mentioned, the importance score of the one or more features may be determined using one or more procedures. For example, a feature permutation may be used to determine an importance score. Permutation feature importance is a model inspection technique. The permutation feature importance is determined by randomly shuffling a single feature value. This procedure breaks the relationship between the feature and the target, i.e. the operating state of the actual system, and is is indicative of how much the model depends on the feature. This procedure benefits from being agnostic with respect to the machine learning model and can be calculated many times with different permutations of the feature. Alternatively, e.g., when the machine learning model is based on linear regression, the linear regression coefficients may be used as importance scores. Alternatively, a classification error may be used as a feature importance score. The classification accuracy is the ratio of number of correct predictions to the total number of predictions. Hence, changing a feature may increase or decrease the accuracy and thus the error. Consequently, a score for one or more features may be obtained. If by changing the feature value the machine learning model's outcome has altered drastically, it means that this feature has a big impact on the prediction.

In general, a sensitivity analysis of the one or more features may be performed. Sensitivity analysis determines how the uncertainty in the output of a system such as a machine learning model allocated to different sources of uncertainty in its inputs, i.e. its features.

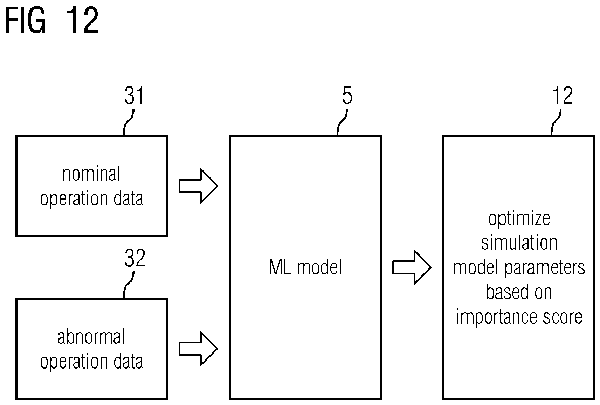

Figure 12 shows further steps of the optimization of simulation model parameters. In the following a simulation model for the failure case based on abnormal operation data 32 is discussed. A simulation model for the "good" case may be obtained by using the measured data for the good case, i.e. the nominal operation data 31, as the input for the optimization, instead of the abnormal operation data 32.

In order to optimize the simulation model, i.e. improve the accuracy between the simulation model output data and the actual system output data, a cost function C may be optimized. As mentioned in the above, the optimization may be focused on the most important features according to the score determined using the machine learning model 5. The simulation model may then be optimized to provide an accurate matching between the features (and/or respective feature values) determined by the simulation model and the actual system as indicated by reference sign 12 in Figure 12.

Having determined the respective score for the features of the machine learning model 5, the cost function may be minimized in order to optimize the simulation model by adapting the simulation model parameters.

For example, the cost function C may take the form:

$$C = \sum_i \omega_i \left| f_i^{sim} - f_i^{meas} \right|$$

where, $f_i^{sim}$ represents the features obtained by the simulation model, $f_i^{meas}$ represents the features obtained by the actual system and where the weight $w_i$ that is based on a feature importance score. As mentioned, features $f_i$ are formed based on the simulation model (output data) and the actual system (output data) and the difference between the (most important) features (as previously extracted) is minimized.

One or more of the following steps may be performed to provide, preferably optimize, a simulation model:

1. Perform a set of measurements for the actual system without failure ("good" case) and the failure case in order to obtain nominal operation data 31 and abnormal operation data 32, e.g., using one or more sensors. In general, actual system output data during the operation of the actual system in one or more operating states may be obtained, e.g., measured. Each measurement may comprise of a pair of time series for the input and the response of the actual system. In the example given concerning the conveyor system, it is a time series for the rotary velocity of the electric drive and a time series for the torque measured at the electric drive. The amount of measurements may affect the performance of the machine learning model.

2. Generate, a feature space from the measured data and build a machine learning model 5 which can distinguish between a good case and the failure case. Feature extraction can be limited to the response part, i.e. the actual system output data, as only the response allows to distinguish between good and bad case, i.e. the operating states of the actual system. Nevertheless actual system input data may be used for the optimization, e.g., for inputting he actual system input data into the simulation model. The machine learning model 5 is thus trained with the measurement data employing state-of-the-art cross-validation techniques and automated hyperparameter tuning. The trained machine learning model 5 is saved and will be later applied to the simulation model output data for inference and classification, respectively.

3. Perform a feature importance analysis on the whole set of measured time series and consider the features which contribute to decision making, i.e. the classification by the machine learning model 5, the most. A cumulated relative importance score of 80% is a good trade-off. Such a choice already reduces the number of features to focus on during the optimization of simulation parameters dramatically, however, leaves enough explanatory power to accurately reproduce the failure case.

As mentioned, different alternative methods can be applied in order to determine the feature importance. For example, the Principal Component Analysis Technique (PCA), but also sensitivity analysis methods that do not involve many calculation exhibiting examples may be used.

After having determined the feature importance score, all information from the whole set of measurements, i.e. the actual system output data, is used and encoded in the machine learning model 5 and the feature importance analysis. The machine learning model may then be used for the optimization of a simulation model based on an importance score of the features extracted.

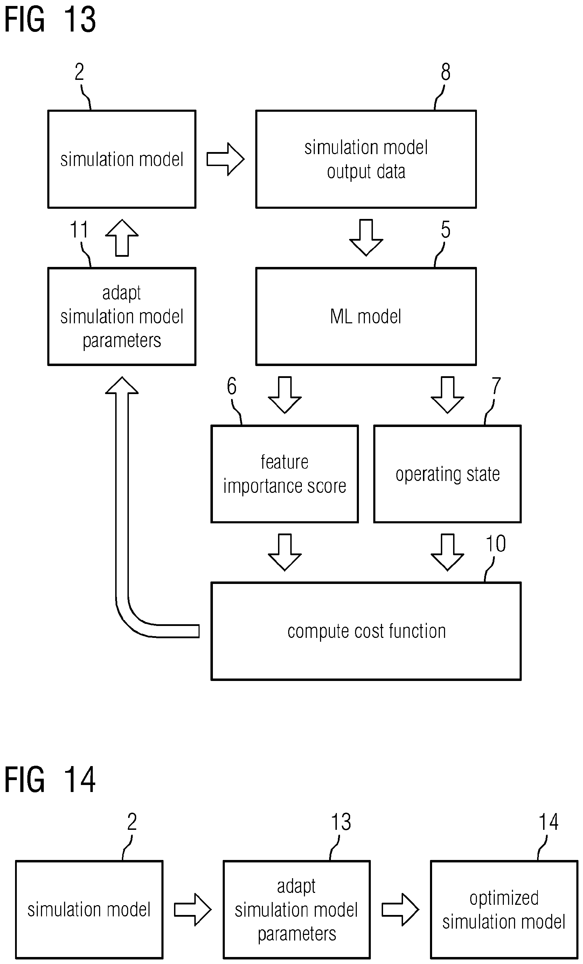

Now, turning to Figure 13 further steps of optimizing a simulation model are described. A single measurement (again a pair of input and response) is picked from the stack of measurements, i.e. the actual system output data, and may serve as input to the simulation model 2 and as reference to the simulated response of the system. Obviously, if the simulation model should be optimized to represent the failure case, a measurement for the failure case must be picked.

One or more of the following steps may be performed in addition to the previous steps 1.-3. or independent thereof:

4. Extract the feature values from the single measurement and/or feed it into the machine learning model 5.

5. Set simulation parameters within adequate ranges and/or run a simulation with the measured input, i.e. the actual system input data, as input to the simulation model. The simulation model output time step and output duration may be synchronized with the sampling rate of the measurement, i.e. the actual system output data. Thereby, simulation model output data 8 is obtained.

Any optimization procedure needs a cost function C which is optimized, as indicated by reference sign 10 in Figure 10. In the present case the cost function C is minimized. The cost function C may take the form:

$$C = \sum_{i} \omega_i \left| f_i^{sim} - f_i^{meas} \right| + \sum_{kl} \lambda(1 - \delta_{kl})$$

In the present example the cost function C consists of two parts which benefit from the initial data analysis (Step 1. - 3.) in different ways, which will described in the following:

6. Extract the features from the simulated response, i.e. the simulation model output data, and calculate their absolute differences, e.g., L1 or L2 norm, to the feature values extracted from the measured reference, i.e. from the actual system output data, as described in step. 5. The contribution from each feature fi can be weighted by the individual feature importance $\omega\_i$. This points the optimization effort to the most important features. The contribution to the cost function C is then the sum of all weighted differences of all features fi, which are considered important, cf. step 3. in the above.

7. Feed the extracted features from the simulated response into machine learning model 5 for inference and classification, respectively. The feature extraction may be part of the machine learning model 5 already or may be performed by a separate software module, not shown. In case the machine learning model 5 leads to misclassification of the simulated data, a penalty term may be added to the cost function C. The scaling factor λ weights this penalty term with respect to the contribution from step 6. In practice the value λ is subject to hyperparameter tuning but can also be set manually. Considering the cost function C as a Lagrange function for optimization of the absolute difference under the boundary condition "no misclassification", λ can be chosen differently for each label k depending on the change of the misclassification with varying simulated feature:

$$\lambda_k = \frac{w_i}{\frac{\partial \delta_{kl}(f_i)}{\partial f_i}}$$

Hence λ can be tuned to find an optimum simulation value for each feature fi. The adaption of the simulation model parameters is indicated by reference sign 11 in Figure 13. 8. A new simulation according to step 5. may be performed, but now with different, optimized simulation model parameters. The procedure starting from step. 1 or from step 4. may be repeated.

This iterative procedure may be repeated until the simulation model parameter space is explored and the value for the cost function C has converged. As mentioned above, a global optimization driver is employed to explore the simulation model parameter space. Advanced techniques, e.g. differential evolutionary algorithms, Bayesian optimization, or the SHERPA algorithm in the Siemens product HEEDS, may be used to perform this task in an efficient way.

As a result of the optimization of the simulation model 2 an optimized simulation model 14 may be obtained, as shown in Figure 14. The optimized simulation model 14 comprises the tuned simulation model parameters and/or parameter values. The optimized model may then be used for condition monitoring of the system and/or for predictive maintenance. To that end the optimized simulation model 14 may for example be deployed on a computer such as the control computer 40 in Figure 4 or may be deployed on an edge device or the cloud where it may be executed by a processing circuitry. Compared to the simulation model 2 the optimized simulation model may comprise additional parameters (for modelling the actual system) and/or different parameter values. Such a change of the simulation model 2 is referred to by reference sign 13 in Figure 14.

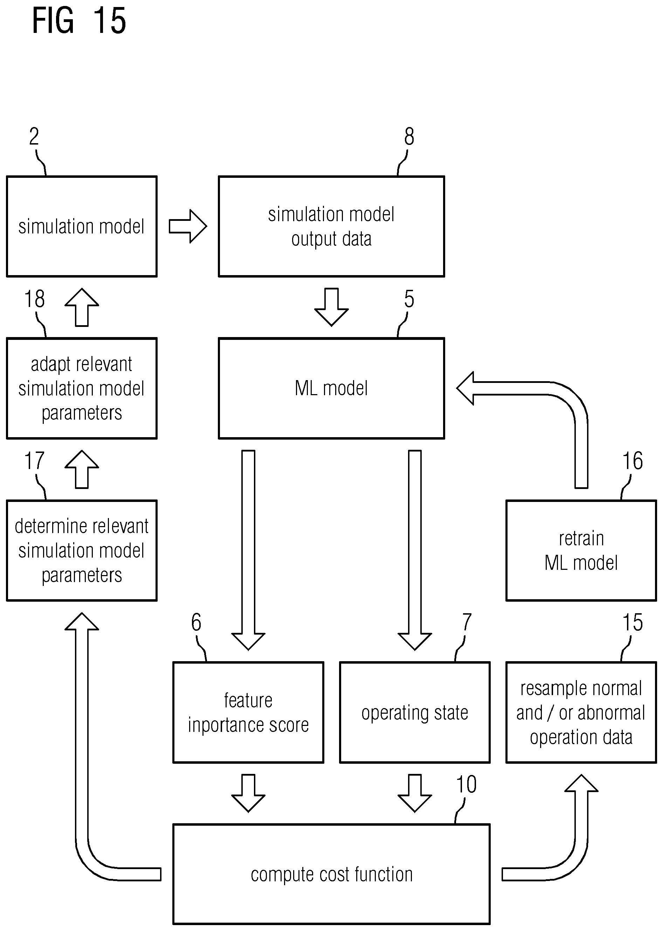

Turning to Figure 15 further steps for optimizing a simulation model 2 will be explained. The "Basic Procedure", as described in connection with Figure 13, may be subject to a systematic problem: Although the information of the entire set of measurements, i.e. the actual system output data, is used to train the machine learning model 5, it only uses one measurement to optimize the simulation model parameters. This may lead to overfitting. The "Generalized Procedure", which will be explained in the following, removes this drawback. The "Basic Procedure" for the optimization of the simulation model (parameters) as described may be repeated with respect to a set of n measurements (batch), not shown. Furthermore, "Basic procedure" can be repeated by repeating the step 1., i.e. choosing a random sample from the overall set of measurements, to create a new batch. Optionally, a PCA or a sensitivity analysis can further support efficient exploration of the simulation model parameter space and determine the simulation model parameters. In the example given in Figure 15, the simulation model 2 is for the failure case. For the good case, all measurements for the "good" case within the batch serve as input for the optimization routine instead.

The system initialization and set up for the "Generalized Procedure" is described in the following:

1. Perform a set of N measurements; as in the "Basic Procedure", in order to obtain actual system input data and actual system output data.
2. Create a batch of data, i.e. a data set, by drawing a random sample of sample size n from the entire set of measurements (batch; n<N)
3. Generate a feature space from the batch (n measurements) and build a machine learning model 5; as in the "Basic Procedure"; alternatively, the machine learning model 5 can also be trained with the entire set of measurements (N measurements)
4. Perform a feature importance analysis on the batch of measurement; as in the "Basic Procedure"; alternatively, the machine learning model 5 can also be trained with the entire set of measurements (N measurements). The resampling of normal and/or abnormal operation data from the set of N measurements is referred to by reference sign 15 in Figure 15. Subsequently as will become apparent later, the machine learning model may be retrained based on the resampled batch (of n<N measurements), referred to by reference sign 16 in Figure 15.

Now, all measurements within the batch with the target label (n' measurements), i.e. a label corresponding to a nominal or abnormal operating state of the actual system, may serve as input to the simulation model and for optimizing the simulation model's parameter:

5. Set simulation parameters within adequate ranges; as in the "Basic Procedure"

6. Now - instead of running one simulation - run n' simulations with the n' measurements as input. As a result, simulation model output data 8 is obtained.

7. Extract the features from the simulated response of the simulation model, i.e. the simulation model output data 8, and calculate their absolute differences, e.g., L1 or L2 norm, to the feature values extracted from the measured reference, i.e. actual system output data, for the n' measurements/simulations. As in the "Basic Procedure", the feature importances can be used as weights in the cost function C. Since the weights might depend on the choice of batch, they are referred to by an extra index w_in'.

8. Feed the extracted features from the simulated response into the machine learning model 5 for inference and classification, respectively. As mentioned, the feature generation and extraction may be part of the machine learning model 5 or may be implemented in a separate software module that interfaces with the machine learning model 5. In case the machine learning model 5 leads to misclassification of the simulated data, a penalty term is added to the cost function C, as in the "Basic Procedure". The scaling factor may be chosen differently for each batch, so it gets an extra index $\lambda_{n'}$. The classification function $\delta_{n'kl}(f_i)$ being a function of the features determines represents the classification algorithm M (0 not correct, 1 correct with intermediate values as distance to correct or not correct). The cost function C to be minimized then may read:

$$C_{n'} = \sum_{j}^{n} \sum_{i} \omega_{in'} \left| f_{ij}^{sim} - f_{ij}^{meas} \right| + \sum_{kl} \lambda_{n'} (1 - \delta_{n'kl}(f_i))$$

9. Sum up contributions from step 8 and step 9 over all n' measurements/simulations, to compute the cost function for the whole batch.

10. Optional step: dimensionality reduction, referred to by reference sign 17 in Figure 15. Extract the simulation model parameter importance score (like in step 3 using sensitivity Analysis or PCA on a trained classifier model) for the optimization by comparing which simulation model parameter has most impact on the overall optimization goal - taking also the classification of the samples of the batch into account. Adjust, referred to by reference sign 18 in Figure 15, the simulation model importance parameters, e.g., by averaging with the previous importance value:

```
parameter_importance_new=
(parameter_importance_calculated+parameter_importance_old)/2
```

or moving averaging incorporating a hyperparameter for smaller impact. This step may be performed once for each individual batch, e.g. at the beginning of each batch optimization.

11. The procedure now is looped until the cost function C converges. The loop can be performed in two different ways:

   a) Inner loop: go back to step 5. and reuse the data from the initial batch and perform a number of optimization steps until the cost function converges
   b) Outer loop: go back to step 2. and start all over with another batch of measurements.
   c) any combination of a) and b).

The present approach employs a data analytics model for feature generation and classification in order to optimize a simulation model. The pipeline which uses the system simulation model topology and a stack of measurement data as input may operate autonomous without any further input from the user. It is thus easy to use and requires no domain expertise, neither on the data analytics side nor on the system simulation models side.

Furthermore, the fact that the data analytics model is generated in an automated manner including automated hyperparameter tuning ensures that the information from the, e.g., measured, actual system output data is used in an optimal way.

**Claims**

1. A method of providing, preferably optimizing, a simulation model (2) of an actual system (1), the actual system (1) having a plurality of operating states (7), comprising the steps of:

obtaining, preferably measured by one or more sensors, actual system output data (4), the actual system output data (4) representing a response of the actual system (1) to system input data (3), preferably also measured by one or more sensors,

determining, by a machine learning model (5), one or more scores (6), the one or more scores (6) indicating an importance of one or more features (9) for classifying the actual system output data (4) and/or the simulation model output data (8) by the machine learning model (5) into at least one of the operating states (7),

identifying one or more parameters (21, 22, 23) of the simulation model (2) based on the one or more scores (6), and

adapting the one or more parameters (21, 22, 23) of the simulation model (2).

2. The method according to the preceding claim further comprising the step of:
   determining, by the machine learning model (2), the one or more features (9) based on the actual system output data (4) and/or the simulation model output data (8); and/or classifying, by the machine learning model (2), the actual system output data (4) and/or the simulation model output data (8) into the one or more operating states (7) of the actual system (1) based on the features (9).

3. The method according to any one of the preceding claims further comprising the step of:
   optimizing, preferably minimizing, a difference between the actual system output data (4) and simulation model output data (8) based on adapting the one or more parameters of the simulation model (2), wherein the one or more parameters (21, 22, 23) are identified based on the one or more scores (6); wherein preferably the step of determining the one or more scores (6) is based on determining, e.g., calculating an increase in, a classification error of the machine learning model (2) when changing one or more features (9).

4. The method according to any one of the preceding claims, wherein the step of determining the one or more scores (6) is based on a principal component analysis of the features (9) for classifying the actual system output data (4) and/or the simulation model output data (8) by the machine learning model (2) into at least one of the operating states (7).

5. The method according to any one of the preceding claims, wherein the step of determining the one or more scores (6) is based on a sensitivity analysis of the features (9) for classifying the actual system output data (4) and/or the simulation model output data (8) by the machine learning model (2) into at least one of the operating states (7).

6. The method according to any one of the preceding claims further comprising the step of:
   wherein the step of classifying comprises classifying the actual system output data (4) and/or the simulation model output data (8) into one or more nominal operating states and/or one or more abnormal operating states of the actual system (1).

7. The method according to any one of the preceding claims further comprising the step of:
   simulating, using the simulation model (2), an abnormal operating state of the actual system (1), wherein behavior of the simulation model (2) is based on the one or more parameters (21, 22, 23).

8. The method according to any one of the preceding claims further comprising the step of:
   obtaining, by the machine learning model (5), simulation model output data (8) from the simulation model (2) based on the actual system input data (2), and preferably determining one or more features (9) for classifying the simulation model output data (8) into the one or more operating states (7) of the actual system (1).

9. The method according to any one of the preceding claims further comprising the step of:
   comparing the one or more features (9) obtained from the actual system output data (4) with the one or more features (9) obtained from the simulation model output data (8), and preferably applying a weight factor based on the score (6) of the features (9).

10. The method according to any one of the preceding claims further comprising the step of:
    classifying, by the machine learning model (5), the simulation model output data (8) into one or more of the operating states (7) of the actual system (1).

11. The method according to any one of the preceding claims further comprising the step of:

    determining a penalty function for the one or more features (9) of the machine learning model (5) in case of a misclassification of the simulation model output data (8) by the machine learning model (5),
adapting one or more parameters (21, 22, 23) of the simulation model (2) based on the penalty function, and
obtaining new simulation model output data based on the one or more parameters (21, 22, 23).

12. The method according to any one of the preceding claims further comprising the step of:

determining a data set by, preferably randomly, selecting samples from the actual system output data (4),
comparing the one or more features (9) obtained from the actual system output data (4) in the data set with the one or more features (9) obtained from the simulation model output data (8) and
preferably applying a weight factor based on the score (6) of the features (9) and most preferably a penalty function in case of a misclassification by the machine learning model (5).

13. The method according to any one of the preceding claims further comprising the step of:
using the simulation model (2) comprising the adapted parameters for testing, condition monitoring, product development, production workflow optimization, control strategy optimization and/or predictive maintenance.

14. The method according to any one of the preceding claims further comprising the step of:
providing a simulation model for each of a plurality of operating states (7) of the actual system (1).

15. An apparatus operative to carry out the method steps of any one of the preceding claims

16. A non-transitory computer-readable storage medium, storing computer-executable instructions that when executed, e.g., by a processing circuitry, perform the steps according to any one of the claims 1 to 14.

# FIG 1

| 3 | | 1 | | 4 |
|---|---|---|---|---|
| actual system input data | ⇒ | actual system | ⇒ | actual system output data |

# FIG 2

| 3 | | 2 | | 8 |
|---|---|---|---|---|
| actual system input data | ⇒ | simulation model | ⇒ | simulation model output data |

# FIG 3

| 3 | | 2 | | 8 |
|---|---|---|---|---|
| measured rotational velocity | ⇒ | simulation model parameters | ⇒ | simulated torque |

# FIG 4

# FIG 5

FIG 6

Frequency-Filtered Input

## FIG 7

```
     3                          2                          8
actual                   simulation model         simulation model
system input data   ⇒                         ⇒   output data
```

```
              adapt
              simulation model   ⇐
              parameters
                    70
```

## FIG 8

```
     31                         80                         21
nominal                  optimize                 optimized
operation data      ⇒    simulation model    ⇒    simulation model
                         parameters               for nominal
                                                  operation
```

## FIG 9

```
     32                         90                         22
abnormal                 optimize                 optimized
operation data      ⇒    simulation model    ⇒    simulation model
                         parameters               for abnormal
                                                  operation
```

# FIG 10

# FIG 11

## FIG 12

```
     31                          5                         12
┌──────────────┐         ┌──────────────┐         ┌──────────────┐
│   nominal    │   ⇨     │              │         │  optimize    │
│operation data│         │              │         │  simulation  │
└──────────────┘         │              │   ⇨     │model parameters│
     32                  │   ML model   │         │  based on    │
┌──────────────┐         │              │         │importance score│
│   abnormal   │   ⇨     │              │         │              │
│operation data│         │              │         │              │
└──────────────┘         └──────────────┘         └──────────────┘
```

## FIG 13

```
        2                              8
┌──────────────────┐      ┌──────────────────┐
│                  │  ⇒   │  simulation model │
│ simulation model │      │   output data     │
│                  │      │                   │
└──────────────────┘      └──────────────────┘
        ⇑ 11                       ⇓        5
┌──────────────────┐      ┌──────────────────┐
│      adapt       │      │                  │
│ simulation model │      │     ML model     │
│   parameters     │      │                  │
└──────────────────┘      └──────────────────┘
        ⇑              6  ⇓            ⇓    7
        │         ┌────────────┐  ┌────────────┐
        │         │  feature   │  │            │
        │         │ importance │  │ operating  │
        │         │   score    │  │   state    │
        │         └────────────┘  └────────────┘
        │              ⇓               ⇓
        │         ┌──────────────────────────┐ 10
        └─────────│                          │
                  │   compute cost function  │
                  │                          │
                  └──────────────────────────┘
```

## FIG 14

```
        2                    13                   14
┌──────────────────┐  ┌──────────────────┐  ┌──────────────────┐
│                  │  │      adapt       │  │                  │
│ simulation model │⇒ │ simulation model │⇒ │   optimized      │
│                  │  │   parameters     │  │ simulation model │
└──────────────────┘  └──────────────────┘  └──────────────────┘
```

# FIG 15

```
      2                                    8
┌──────────────────┐        ⇨    ┌──────────────────────┐
│                  │             │   simulation model   │
│ simulation model │             │     output data      │
│                  │             │                      │
└──────────────────┘             └──────────────────────┘
      ⇧                                    ⇩         5
  18 ┌──────────────────┐        ┌──────────────────────┐ ⇐─────────┐
     │  adapt relevant  │        │                      │           │
     │ simulation model │        │       ML model       │           │
     │    parameters    │        │                      │           │
     └──────────────────┘        └──────────────────────┘           │
      ⇧                            ⇩              ⇩        16        │
  17 ┌──────────────────┐                          ┌────────────────┴─┐
     │ determine relevant│                         │     retrain      │
     │ simulation model │                          │     ML model     │
     │    parameters    │                          │                  │
     └──────────────────┘                          └──────────────────┘
      ⇧              6 ⇩            7 ⇩            15 ⇩
     ┌──────────────┐  ┌──────────────┐  ┌──────────────────┐
     │   feature    │  │              │  │ resample normal  │
     │  inportance  │  │   operating  │  │  and / or abnormal│
     │    score     │  │    state     │  │  operation data  │
     └──────────────┘  └──────────────┘  └──────────────────┘
      ⇧         ⇩              ⇩              ⇧
     └─────┐  ┌──────────────────────────────────┐ 10
          │  │                                    │
          └──│       compute cost function        │──┘
             │                                    │
             └──────────────────────────────────┘
```

Europäisches
Patentamt

European
Patent Office

Office européen
des brevets

**EUROPEAN SEARCH REPORT**

Application Number

EP 21 16 5949

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KAPTEYN MICHAEL G. ET AL: "Toward predictive digital twins via component-based reduced-order models and interpretable machine learning", AIAA SCITECH 2020 FORUM, 6 January 2020 (2020-01-06), XP055833627, Reston, Virginia DOI: 10.2514/6.2020-0418 Retrieved from the Internet: URL:https://kiwi.oden.utexas.edu/papers/Predictive-digital-twin-interpretable-machine-learning-Kapteyn-Knezevic-Willcox.pdf> * figures 3,10 * * page 1, paragraph 1 * * page 2, paragraph 3 * * page 2, paragraph second-last * * Section II.A par.3 * * eqn (5); par.2; page 5 * * page 5, paragraph 3 * * page 6, paragraph 2 * * Section III.B par.2 * * Section IV.A par.1 * * page 15, paragraph 3 * * Section V * * the whole document * ----- -/-- | 1-16 | INV. G06F30/27 |

TECHNICAL FIELDS SEARCHED (IPC)

G06F

The present search report has been drawn up for all claims

| Place of search | Date of completion of the search | Examiner |
|---|---|---|
| Munich | 20 August 2021 | Dapp, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 21 16 5949

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MOHAMED HABIB FARHAT ET AL: "Digital twin-driven machine learning: ball bearings fault severity classification", MEASUREMENT SCIENCE AND TECHNOLOGY, IOP, BRISTOL, GB, vol. 32, no. 4, 16 February 2021 (2021-02-16), page 44006, XP020365181, ISSN: 0957-0233, DOI: 10.1088/1361-6501/ABD280 [retrieved on 2021-02-16] * abstract; figure 3 * * Section 2.1 par.1 * * eqn.(2); page 3, left-hand column, last paragraph - paragraph 2 * * page 2, left-hand column, paragraph 1 * * section 3.2.2 * * page 6, left-hand column, paragraph 1 * * the whole document * | 1,15,16 | |
| A | Tiger Analytics: "ML-Powered Digital Twin For Predictive Maintenance", , 18 December 2020 (2020-12-18), XP055833631, Retrieved from the Internet: URL:https://analyticsindiamag.com/ml-powered-digital-twin-for-predictive-maintenance-notes-from-tiger-analytics/ [retrieved on 2021-08-20] * the whole document * | 1-16 | TECHNICAL FIELDS SEARCHED (IPC) |

The present search report has been drawn up for all claims

| Place of search | Date of completion of the search | Examiner |
|---|---|---|
| Munich | 20 August 2021 | Dapp, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 068 140 A1**

**Patent documents cited in the description**

- WO 2018089957 A1